# EUROPEAN PATENT APPLICATION

(11) **EP 2 587 902 A1**
(43) Date of publication of application: **01.05.2013**
(21) Application number: 11798163.9
(22) Date of filing: 22.06.2011
(51) Int. Cl.: H05K 5/02, B24C 1/06, C23C 24/04, C23C 24/08, H05K 5/04

(54) **COMMUNICATIONS DEVICE AND PRODUCTION METHOD FOR COMMUNICATIONS DEVICE CASE**

(30) Priority: 25.06.2010 JP 2010144879
(71) Applicant: NEC Corporation, Tokyo 108-8001 (JP)
(72) Inventor: SHIMIZU, Masatoshi, Tokyo 108-8001 (JP); NOMURA, Masahiro, Tokyo 108-8001 (JP)
(74) Representative: Glawe, Delfs, Moll
(86) International application number: PCT/JP2011/064219
(87) International publication number: WO 2011/162281

(57) **Abstract**

An enclosure that contains a transmission section and a reception section of an ODU is protected against hard environments without it being necessary to apply a coating of paint to the enclosure. The present invention is communication device (ODU) (1) installed outdoors, including a transmission section that transmits a signal; a reception section that receives a signal; and an enclosure that contains the transmission section and the reception section. In the device, the enclosure of ODU (1) is made of a nonferrous metal and an outer surface of the nonferrous metal is coated with paint, but a concave and convex pattern of an impact mark of powder particles is successively formed thereon.

## Description

### TECHNICAL FIELD

The present invention relates to a communication device installed outdoors, in particular, to a structure and a producing method for an enclosure that accommodates a transmission section and a reception section that make up the communication device.

### BACKGROUND ART

Mobile communication systems represented by portable telephone systems form an access network that connects radio base stations. Such an access network connects radio base stations using cable communication or radio communication. In particular, when an access network is established using radio communication, it has advantages that include establishing low cost networks and a high degree of freedom in selecting the radio base station installation area. Radio communication performed between radio base stations uses microwave radio communication devices. Such radio communication devices need to be installed at high places such as pylons or rooftops of buildings such that radio communication is not obstructed. Such radio communication devices are categorized as outdoor devices installed close to antennas that are also installed at high places (hereinafter these outdoor devices units are referred to as ODUs) and indoor devices installed apart from the ODUs (hereinafter these indoor devices units are referred to as IDUs). The ODU and the IDU are connected by a coaxial cable or the like (refer to Patent Literature 1). Since the ODU along with the antenna is installed a high outdoor elevation, it's functionality is limited to transmitting and receiving a signal to and from the antenna which results in the ODU being small and light. In contrast, the IDU is provided with more complicated functions that modulate, demodulate, and process a signal and is installed indoors such that the IDU itself can be easily maintained and such that its reliability is improved.

In such a radio communication device that communicates between base stations, the ODU is installed outdoors where installation environment is particularly severe, occasionally, in the desert, cold area, or seashore. Moreover, the ODU tends to be installed at a place where it is very difficult to frequently maintain and inspect (for example, a high place such as a pylon). Thus, the ODU needs to be able to designed so that it can operate in a very adverse environment. To satisfy such requirements, precision electronic parts such as a transmission circuit and a reception circuit that make up the ODU are contained in a rigid metal enclosure. In addition, the surface of the metal enclosure is normally coated with a resin paint so as to ensure durability and resistance to corrosion.

Such a coating of paint can slow down the speed with which the metal enclosure, that forms the ODU, corrodes and thus enhance the reliability of the device. Moreover, if the enclosure is coated with a white paint, it can prevent absorption of sun light to which the metal enclosure is exposed so as to impede heat from reaching the inside of the ODU. Such paint coating is however expensive.

Nowadays, due to severe global competitions, further reductions in the installation costs of communication infrastructures are required. To meet such requirements, the applicant of the present invention and those involved in the present invention are considering not to coat the surface that encloses the ODU with expensive paints. In addition, from the perspective of protecting the environment, the applicant et al. also have thought of a method in which paint that does not need an organic solvent can be used.

However, if the ODU is placed for a long time in such a severe outdoor environment in which the enclosure lacks a coating of paint, the precision electronic parts of the ODU would be adversely affected due to corrosion of the enclosure and so forth. When the enclosure of the ODU is cast, it can be quantitatively produced and the cost reduced. However, just after the enclosure is removed from the die, a metal flow mark, cast mark, or the like might appear on the surface of the enclosure. Thus, such an appearance on the surface of the enclosure would have a problem from a point of view of product value.

[Patent Literature 1] JP2006-197343A, Publication

### SUMMARY OF THE INVENTION

The present invention was made from a point of view of the foregoing problem. An object of the present invention is to ensure that metal enclosure that contains a transmission section and a reception section of an ODU is resistant to the adverse effects of a severe environment without it being necessary to apply a coating of paint to the enclosure.

An aspect of the present invention is a communication device installed outdoors, including a transmission section that transmits a signal; a reception section that receives a signal; and an enclosure that contains the transmission section and the reception section,
In the device according to the present invention, the enclosure is made of a nonferrous metal and an outer surface of the nonferrous metal is not coated with paint, but a concave and convex pattern of an impact mark of powder particle is successively formed thereon.

Another aspect of the present invention is a method for producing an enclosure of a communication device installed outdoors, including forming said enclosure of a nonferrous metal by a die cast process; having powder particles impact an outer surface of said enclosure that has been formed; and successively forming a concave and convex pattern of an impact mark of the powder particles on said outer surface.

### BRIEF DESCRIPTION OF DRAWINGS

[Fig. 1] is a perspective view showing that an outdoor radio communication device (ODU) according to an embodiment of the present invention has been installed.
[Fig. 2] is a front view and a rear view of the ODU shown in Fig. 1.
[Fig. 3] is perspective views showing the front side and the rear side of the ODU shown in Fig. 1.
[Fig. 4] is a schematic diagram showing that a concave and convex pattern is formed on the surface of an enclosure of the ODU according to the present invention.
[Fig. 5] is a sectional schematic diagram showing an outer surface and inside of a nonferrous metal that makes up the enclosure of the ODU shown in Fig. 2.
[Fig. 6] is schematic diagrams showing the states of the surface of the enclosure before and 192 hours after a corrosive gas test was conducted.
[Fig. 7] is schematic diagrams showing the states of the surface of the enclosure before and 120 hours after a saline spray test was conducted.
[Fig. 8] is schematic diagrams showing the outer surface of the enclosure in which a mottled mark (metal flow mark) that occurs in a cast product as the enclosure of the ODU shown in Fig. 2 is removed by having powder particles impact the outer surface so as to improve the appearance.
[Fig. 9] is a block diagram showing an example of a radio communication system having a radio communication outdoor device according to the present invention.
[Fig. 10] is a block diagram showing an example of a circuit contained in the outdoor device shown in Fig. 9.

### DESCRIPTION OF REFERENCE NUMERALS

| | |
|---|---|
| 1 | Outdoor radio communication device (ODU) |
| 1A | Cover |
| 1B | Case |
| 2 | Nonferrous metal |
| 2a | Concave and convex pattern |
| 2b | Oxide layer |
| 3 | Antenna |
| 4 | Pole |
| 5 | Joint portion |
| 6 | Handle |
| 11 | A station (base station) |
| 12, 22 | IDU |
| 13, 23 | ODU |
| 14,24 | Antenna |
| 15,25 | Coaxial cable |
| 21 | B station (base station) |
| 31 | Multiplexer circuit |
| 32 | Transmission and reception circuit |
| 33 | Control circuit |

### MODES FOR CARRYING OUT THE INVENTION

Next, with reference to the accompanying drawings, embodiments of the present invention will be described.

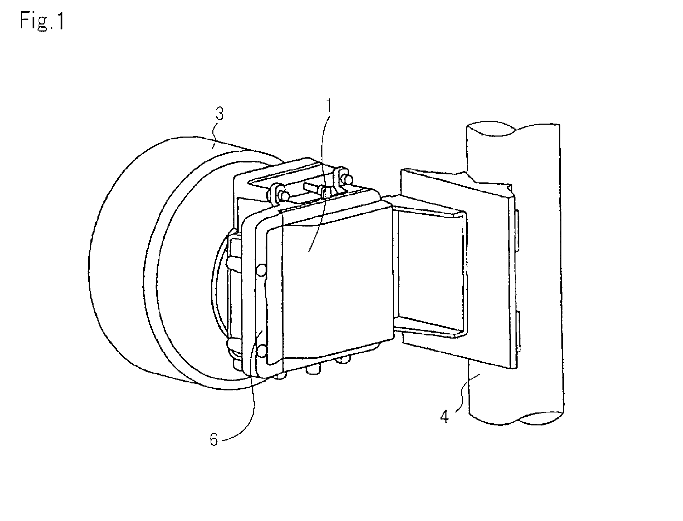

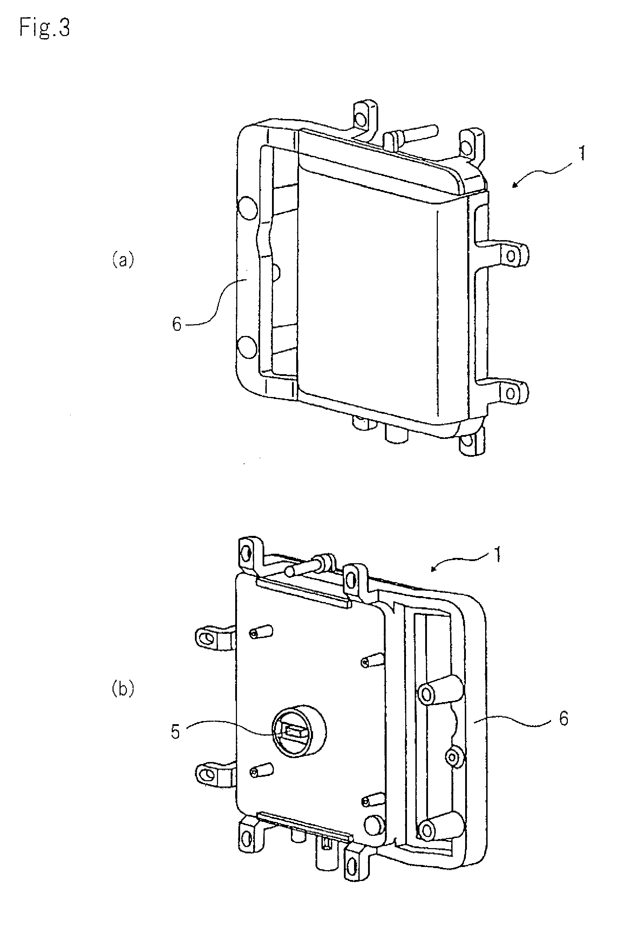

Fig. 1 is a perspective view showing that an outdoor radio communication device (ODU) according to an embodiment of the present invention has been installed. ODU 1 according to this embodiment shown in the drawing comprises a transmission section (not shown) that transmits a radio signal; a reception section (not shown) that receives a radio signal; and an enclosure that contains at least these sections. Assembled in ODU 1 is, for example, antenna 3 as shown in Fig. 1. Antenna 3 transmits a radio signal that is output from the transmission section to the outside and receives a radio signal that is output to the reception section from the outside. ODU 1 has a joint portion (refer to reference numeral 5 shown in Fig. 3) that connects ODU 1 to antenna 3. ODU 1 is secured to pole 4 mounted for example on the rooftop of a building.

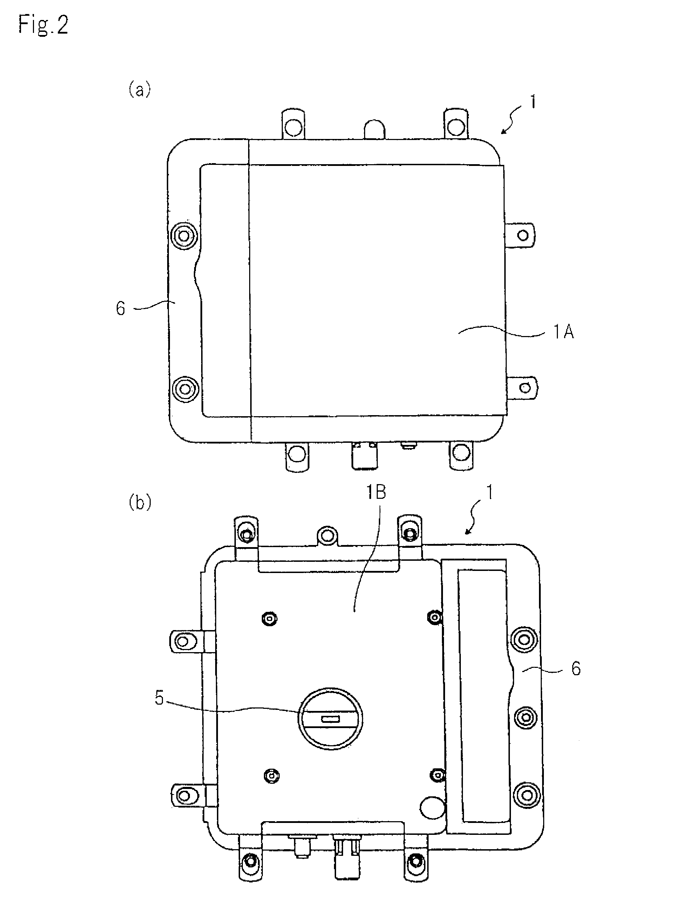

Fig. 2 shows ODU 1: Fig 2(a) is a front view of ODU 1 and Fig. 2(b) is a rear view of ODU 1. Fig. 3(a) is a perspective view showing the front side of ODU 1 and Fig. 3(b) is a perspective view showing the rear side of ODU 1. The enclosure of ODU 1 shown in these drawings is made up of cover 1A and case 1B. The enclosure contains the transmission section and the reception section. ODU 1 also has handle 6 that allows the user to easily carry ODU 1 itself and to easily set the transmission and reception directions. Handle 6 may be integrated with case 1B. If the enclosure and handle 6 are integrated, the number of parts of ODU 1 can be decreased.

The enclosure is made of a nonferrous metal. Although the enclosure may be produced by cutting a material, if the enclosure is quantitatively produced, it is formed by a die cast process. The material of the enclosure is a nonferrous metal. Examples of the material of the enclosure include aluminum, an aluminum alloy, and a zinc alloy. Since these nonferrous metals are light and can be easily machined and especially easily produced by a die cast process, they are suitable for the enclosure of ODU 1. When the enclosure of ODU 1 is formed by the die cast process, it can be easily quantitatively produced and its cost can be reduced.

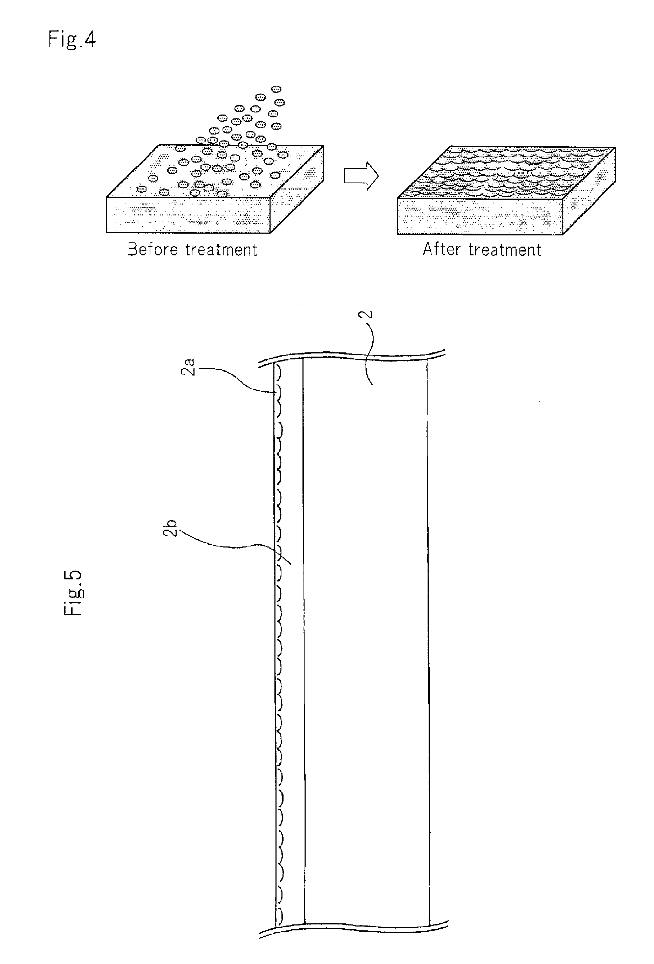

According to the present invention, powder particles are uniformly sprayed at a high speed on the surface of the enclosure of the ODU instead of the surface being coated with paint such that a concave and convex pattern is successively formed on the entire surface of a nonferrous metal. The concave and convex pattern is the impact mark of the powder particles. Likewise, a concave and convex pattern is formed on the surface of a nonferrous metal that forms handle 6 in the same manner as the enclosure. If handle 6 and the enclosure are integratedly formed, they could be effectively treated at once. Fig. 4 shows the state in which a concave and convex pattern is formed as described above.

Examples of the material of the powder particles include stainless steel, glass beads, and aluminum oxide (alumina). The powder particles may be sprayed by an impeller type spray device or an air nozzle type shot peening device.

Next, the concave and convex pattern formed on the surface of the enclosure will be described in detail.

In the case that the nonferrous metal that forms the enclosure of ODU 1 is an aluminum alloy and the powder particles that are sprayed thereto is powder particles of stainless steel, physical treatments for a surface layer of an aluminum alloy will be described.

Assuming that the grain diameter of power particles that are made of the stainless steel is 0.5 mm (specific gravity σ = 7.8 g/cm³) and the impact speed V of the powder particle to the aluminum alloy is 50 m/s, the energy of one grain of the powder particles that is generated when it impacts to the aluminum alloy is 4.786 x 10⁻⁴ [J] because of E = 1/2 mV² (where m = σ x 4/3 x πr³). When such impact based energy is applied to the surface of the aluminum alloy, it is expected that the surface temperature of the aluminum alloy will instantaneously rise to around 1000 °C.

When such a high temperature is instantaneously applied to the surface of the aluminum alloy having a melting point of around 700 °C, it is expected that the surface layer of the aluminum alloy will be microscopically re-melted. It is also expected that this situation will occur in nonferrous metals having melting points of 1000 °C or lower such as aluminum (melting point = 660 °C) and zinc alloy (melting point = around 600 °C).

When the surface layer of such an aluminum alloy is subjected to physical treatments, namely, when the surface layer is instantaneously heated, cooled, and compressed, the outer surface layer of the aluminum alloy is modified to consist of a microscopic metal composition and an oxide film. Fig. 5 is a sectional view schematically showing the outer surface and inside of a nonferrous metal on which a concave and convex pattern is formed in such a manner. As shown in the drawing, concave and convex pattern 2a is formed on the outer surface of nonferrous metal 2 and the outer surface is re-melted and modified into oxide layer 2b.

Specifically, heat that occurs when powder particles of microscopic grains impact the surface of a nonferrous metal at a high speed causes a series of actions of re-melting, quenching, and solidification to be instantaneously repeated. At this point, oxygen in air and the metal of the surface layer react and thereby an oxide is formed. The inventors et al. confirmed that such an oxide is formed when powder particles that are made of stainless steel having grain diameters φ ranging around 0.2 to 1.2 mm impact an aluminum alloy at a speed as high as 50 to 100 m/sec.

If the nonferrous metal that makes up the enclosure of the ODU is an aluminum alloy, when it is re-melted due to the heat that is generated when the powder particles impact the nonferrous metal, an oxide film mainly containing aluminum oxide (Al₂O₃) is formed on the surface of the aluminum alloy. Such an oxide itself has a high resistance to corrosion. In addition, the oxide film formed on the surface due to the heat that is generated when the powder particles impact a surface is thicker than an oxide film that forms naturally on the surface.

In addition, the outer surface layer of the aluminum alloy is microscopically formed due to quick heating and quick cooling. As a result, since the metal composition of the surface layer of the aluminum alloy is more microscopically formed than the inside of the aluminum alloy, the resistance of the enclosure of ODU 1 to corrosion is improved. Moreover, since the oxide film formed on the surface of the base material is harder than the base material itself, it is expected that the abrasion resistance and scratch resistance of the resultant enclosure will be improved.

In addition, spraying of powder particles that are made of stainless steel causes a concave and convex pattern of an impact mark to be successively formed on the entire surface of the enclosure. It is preferred that the surface roughness Ra (average roughness along center line) of the concave and convex pattern be in a range from several to several ten µm. The average diameter φ of the concaves of the surface roughness in this range is around several hundred µm.

In the foregoing, an example in which powder particles that are made of stainless steel impact the surface of an aluminum alloy was described. However, if powder particles of alumina or glass beads that are hard and fragile instead of that of stainless steel impact the surface of an aluminum alloy, not only is an oxide formed, but powder particles are also pulverized and melt on the surface layer of the aluminum alloy. Thus, when powder particles that made of stainless steel are used, since other metal elements except aluminum can be scattered as an oxide alloy on the surface, it can be expected to have a higher resistance to corrosion resistance than the case in which powder particles, that are made of stainless steel, are sprayed.

As described above, according to the present invention, hard and microscopic powder particles impact the outer surface of a nonferrous metal for the enclosure at a high speed and the outer surface layer of the nonferrous metal is modified using the heat that is generated when powder particles impact the outer surface of the nonferrous metal. Thus, it can be expected that a metal oxide will be formed on the surface of a nonferrous metal having a relatively lower melting point (for example, 1000 °C or less) in the same manner as an aluminum alloy and such a nonferrous metal can be used for the material of the enclosure.

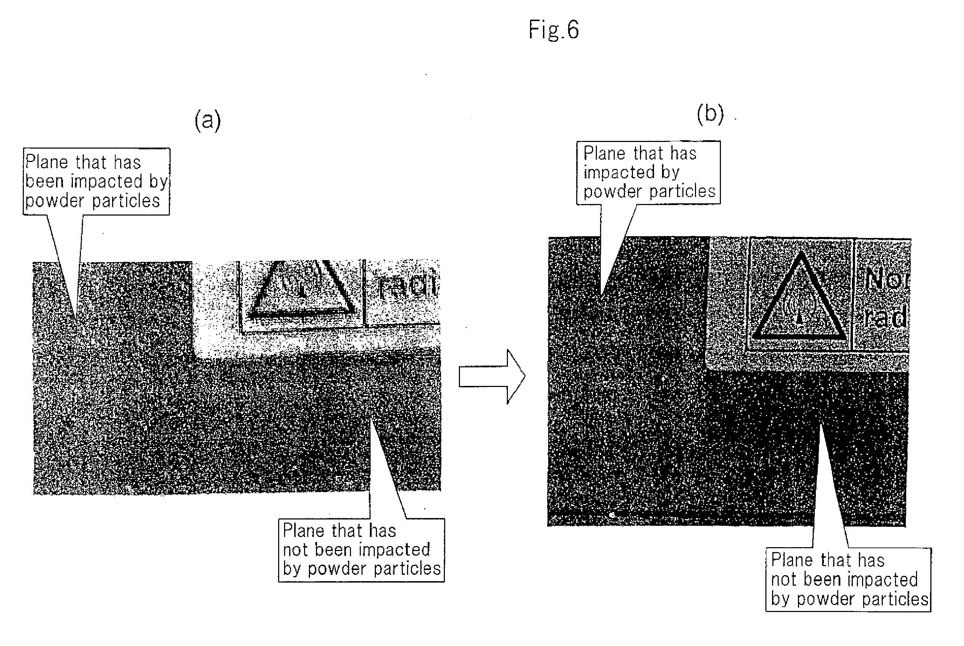

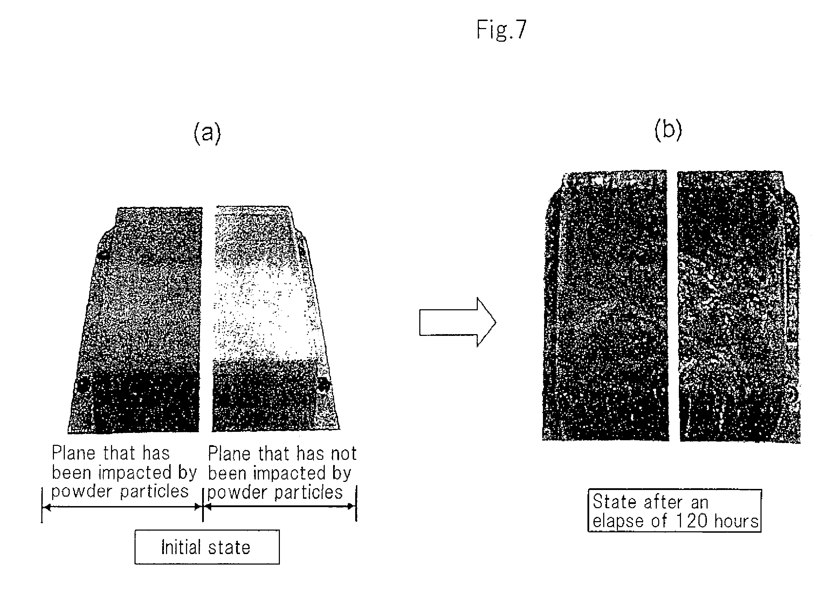

As described above, the metal composition of the modified surface of a nonferrous metal that makes up enclosure 2 is more microscopically formed than the metal composition of the inside of the nonferrous metal and the oxide film formed in the treatment is thicker than the oxide film that forms naturally. Thus, the resistance to corrosion and durability of nonferrous metal 2 are improved compared with those of a nonferrous metal that has not been treated (refer to Fig. 6 and Fig. 7). Consequently, enclosure 2 that contains the transmission and reception circuits of ODU 1 installed outdoors where the environment in which the ODU1 is installed is very severe, has excellent properties for dealing with harsh environments.

Fig. 6 shows the states of the surface of the enclosure before and 192 hours after a corrosive gas test was conducted. The specifications of the corrosive gas test comply with IEC 61587-1 standard. As shown in Fig. 6(a), a plane to which has been impacted by powder particles and a plane which has not been impacted by powder particles were formed on the surface of the enclosure of ODU 1. Thereafter, sulfur dioxide gas (SO₂, concentration = 25 ppm) was sprayed on the surface of the enclosure successively for 96 hours. Thereafter, sulfur hydrogen gas (H₂S, concentration = 10 ppm) was sprayed on the surface of the enclosure successively for 96 hours. In this test, the environmental temperature was 40 °C and the environmental humidity was 80 %RH. The plane which was impacted by powder particles was hardly discolored compared with the plane which was not impacted by powder particles 192 hours after the corrosive gas test was conducted (refer to Fig. 6(b)).

Fig. 7 shows the states of the surface of the enclosure before and 120 hours after a saline spray test was conducted. The specifications of the saline spray test comply with IEC 60068-2-11 standard. As shown in Fig. 7(a), a plane to which has been impacted by powder particles and a plane which has not been impacted by powder particles were formed on the surface of the enclosure of ODU 1. Saline having a concentration of 5 % was sprayed to the surface of the enclosure at a temperature of 35 °C successively for 120 hours. The plane to which powder particles had been impacted was hardly discolored compared with the plane which was not impacted by powder particles (refer to Fig. 7(b)).

As described above, the corrosive gas test and saline spray test confirmed that the present invention improves the resistance to corrosion and durability of the enclosure of ODU 1.

Since the surface of the enclosure has such excellent corrosion resistance properties and durability, it does not require expensive coating with paint. Since it is not necessary to coat the surface with paint that uses an organic solvent, an enclosure can be provided that addresses environmental concerns.

In addition, when the grain diameter, material, impact speed, and so forth of powder particles are appropriately selected, the enclosure can have a surface roughness Ra which makes it difficult for fingerprints to adhere to the surface.

In addition, since impacting of powder particles causes a concave and convex pattern to be formed on the surface of the enclosure and thereby results in an increase in the surface area and exposure of the surface of the enclosure, which is not coated with resin, to the outside, an increase in thermal radiation in the enclosure can be expected.

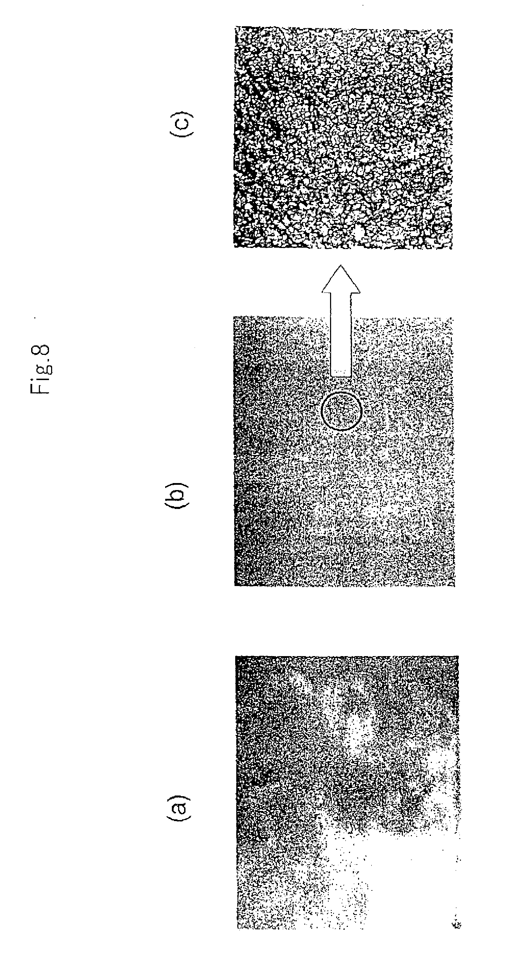

If the enclosure is formed by a die cast process, a metal flow mark appears on the surface of the enclosure when it is removed from the die (refer to Fig. 8(a)). This die cast product itself does not have a good aesthetic appearance. According to the present invention, since surface treatment is conducted, in which the surface of the enclosure is impacted by the powder particles consisting of microscopic grains, the metal flow mark disappears from the surface of the die cast product. In addition, a microscopic concave and convex pattern of an impact mark is uniformly formed on the surface of the enclosure (refer to Fig. 8(b) and Fig. 8(c)). Fig. 8(a) is a photo showing the surface of the enclosure that is a die cast product in which such a metal flow mark appears and Fig. 8(b) is a photo showing the surface of the enclosure on which a microscopic concave and convex pattern that is an impact mark is uniformly formed (same magnification as that shown in Fig. 8(a)). Fig. 8(c) is a photo showing an enlarged view (magnification 50 x) of a surrounded portion of Fig. 8(b).

As described above, according to the present invention, since a concave and convex pattern is successively formed on the entire outer surface of the enclosure that is made of a nonferrous metal, the enclosure of an outdoor radio communication device that contains a reception section and a transmission section will be protected against harsh environments without it being necessary to coat the surface of the enclosure with paint.

### (Applicable Example)

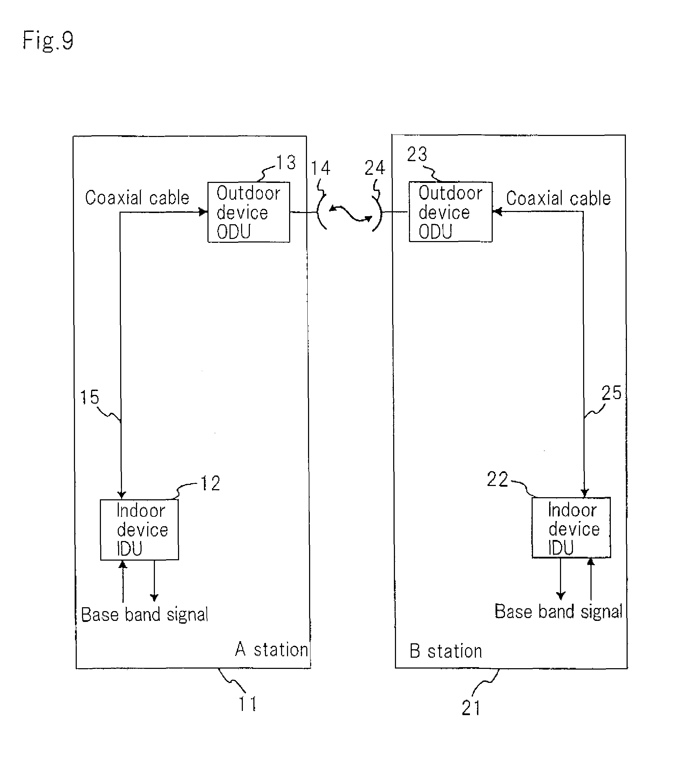

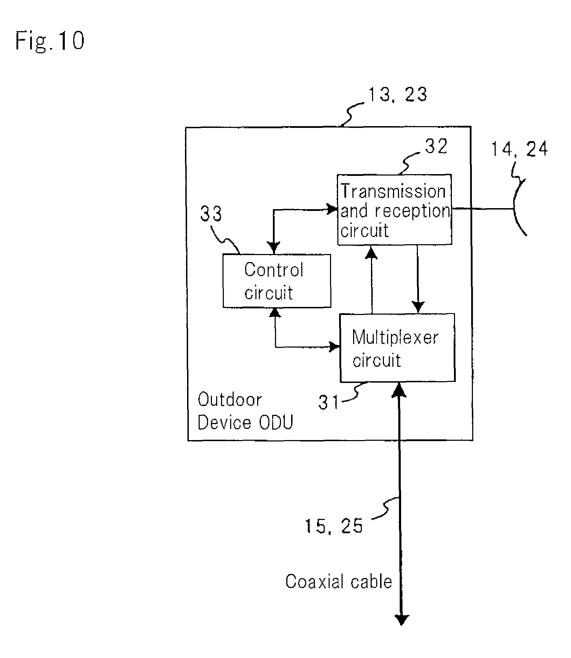

Fig. 9 is a block diagram showing an example of a radio communication system having a radio communication outdoor device (ODU) according to the present invention. Fig. 10 is a block diagram showing an example of circuits contains in the outdoor device shown in Fig. 9.

In Fig. 9, A station 11 (B station 21) has IDU 12 (22) that inputs and outputs a base band signal of one channel and modulates and demodulates the base band signal; ODU 13 (23) that is a radio transmitter and receiver; one coaxial cable 15 (25) that interfaces between IDU 12 (22) and ODU 13 (23); and antenna 14 (24) that is connected to ODU 13 (23) and that transmits and receives a radio signal to and from an opposite station.

As shown in Fig. 10, ODU 13 (23) of A station 11 (B station 21) has multiplexer circuit 31, transmission and reception circuit 32, and control circuit 33. Although Fig. 10 shows transmission and reception circuit 32 in which a transmission circuit and a reception circuit are integrated, these circuits may be independently provided.

Multiplexer circuit 31 of ODU 13 (23) has a function that demultiplexes a multiplexed signal that is input from the IDU side through coaxial cable 15 (25), supplies a DC power to each circuit, and outputs a control signal to control circuit 33. Multiplexer circuit 31 also has a function that separates and extracts a modulation wave from an input signal and outputs the extracted modulation wave to transmission and reception circuit 32 and outputs a demodulation intermediate frequency signal that is input from transmission and reception circuit 32 to the IDU.

Transmission and reception circuit 32 of ODU 13 (23) has a function that converts the modulation wave that is input from multiplexer circuit 31 into a radio frequency signal and transmits the radio frequency signal from antenna 14 (24), and a function that converts a radio frequency signal received by antenna 14 (24) into a demodulation intermediate frequency signal and outputs the demodulation intermediate frequency signal to multiplexer circuit 31.

Control circuit 33 of ODU 13 (23) has a function that controls communication between the IDU and ODU and a function that monitors the control operation of ODU 13 (23) itself.

In the radio communication system that has the foregoing structure, a multiplexed signal that is input from IDU 12 (22) to ODU 13 (23) is separated into DC power, control signal, and modulation wave by multiplexer circuit 31 and then the modulation wave is output to transmission and reception circuit 32. The modulation wave that is input to transmission and reception circuit 32 is converted into a radio frequency signal (RF signal) by transmission and reception circuit 32 and then transmitted to the opposite station through antenna 14 (24). On the other hand, an RF signal received from the opposite station by antenna 14 (24) is converted into a demodulation intermediate frequency signal by transmission and reception circuit 32 and then output to IDU 12 (22) through multiplexer circuit 31 and coaxial cable 15 (25). The example shown in Fig. 7 denotes that one base station has an IDU and an ODU that are independent from each other. However, it should be appreciated that the present invention is applied to the case in which the IDU and ODU are integrated.

Precision electronic parts such as multiplexer circuit 31, transmission and reception circuit 32, and control circuit 33 that perform the foregoing operations are contains in the enclosure of ODU 1 shown in Fig. 1 to Fig. 3. The enclosure of ODU 1 according to the present invention has an outer surface that will be protected against harsh environments without it being necessary to coat the surface of the enclosure with paint. Thus, the enclosure of ODU 1 can securely protect the foregoing electronic circuits in a severe outdoor environment.

Although the present invention was described using the outdoor radio communication unit (ODU), it should be appreciated that the present invention can be applied to an enclosure for a cable communication device rather than a radio communication device.

The present invention has been described with reference to the embodiments. However, it should be understood by those skilled in the art that the structure and details of the present invention may be changed in various manners without departing from the scope of the present invention.

The present application claims a priority based on Japanese Patent Application JP 2010-144879 filed on June 25, 2010, the entire contents of which are incorporated herein by reference in its entirety.

## Claims

1. A communication device installed outdoors, comprising:
a transmission section that transmits a signal;
a reception section that receives a signal; and
an enclosure that contains the transmission section and the reception section,
wherein the enclosure is made of a nonferrous metal and an outer surface of the nonferrous metal is not coated with paint, but a concave and convex pattern of an impact mark of powder particles is successively formed thereon.

2. The communication device as set forth in claim 1,
wherein said outer surface is coated with an oxide of said nonferrous metal.

3. The communication device as set forth in claim 1 or 2,
wherein the outer surface of said nonferrous metal has a more microscopic metal composition than the inside of said nonferrous metal.

4. The communication device as set forth in any one of claims 1 to 3,
wherein said outer surface is re-melted and modified into an oxide layer.

5. The communication device as set forth in any one of claims 1 to 4,
wherein said nonferrous metal is formed by a die cast process.

6. The communication device as set forth in any one of claims 1 to 5,
wherein said nonferrous metal is an aluminum alloy.

7. The communication device as set forth in claim 2,
wherein the oxide of said nonferrous metal is aluminum oxide.

8. The communication device as set forth in any one of claims 1 to 7,
wherein concaves of said concave and convex pattern have an average diameter φ of several hundred µm.

9. The communication device as set forth in any one of claims 1 to 8,
wherein the roughness Ra (average roughness along center line) of the outer surface of said nonferrous metal is in the range from several to ten several µm.

10. The communication device as set forth in any one of claims 1 to 9,
wherein said concave and convex pattern is formed on the entire outer surface of said enclosure.

11. The communication device as set forth in any one of claims 1 to 10,
wherein said enclosure has a handle, the handle is also made of a nonferrous metal, and the outer surface of the nonferrous metal is not coated with paint, but a concave and convex pattern of a impact mark of powder particles is formed thereon.

12. The communication device as set forth in any one of claims 1 to 11,
wherein said housing has a joint portion connected to an antenna that transmits a signal that is input from said transmission section to the outside and receives a signal that is output to said reception section from the outside.

13. The communication device as set forth in any one of claims 1 to 12,
wherein said concave and convex pattern of said outer surface is formed when powder particles impact the outer surface.

14. The communication device as set forth in claim 4,
wherein said outer surface is re-melted with heat that occurs when powder particles impact to said outer surface.

15. The communication device as set forth in claim 13 or 14,
wherein said powder particle is a powder particle that consists of glass beads, stainless steel, or aluminum oxide.

16. The communication device as set forth in any one of claims 13 to 15,
wherein the grain diameter φ of said powder particle is in the range from 0.2 to 1.2 µm.

17. The communication device as set forth in any one of claims 13 to 16,
wherein the impact speed of said powder particle is 50 to 100 m per second.

18. A producing method for an enclosure of a communication device installed outdoors, comprising:
forming said enclosure made of a nonferrous metal by a die cast process;
having powder particles impact an outer surface of said enclosure that has been formed; and
successively forming a concave and convex pattern of an impact mark of the powder particles on said outer surface.

19. The producing method as set forth in claim 18,
wherein said outer surface is coated with an oxide of said nonferrous metal that is formed as said concave and convex pattern.

20. The producing method as set forth in claim 18 or 19,
wherein said outer surface is modified into an oxide layer.

21. The producing method as set forth in any one of claims 18 to 20,
wherein said powder particle is a powder particle that consists of is powder of glass beads, stainless steel, or aluminum oxide.

22. The producing method as set forth in any one of claims 18 to 21,
wherein the grain diameter φ of said powder particle is in the range from 0.2 to 1.2 µm.

23. The producing method as set forth in any one of claims 18 to 22,
wherein the impact speed of said powder particle is 50 to 100 m per second.
